(19)

Europäisches Patentamt

European Patent Office

Office européen des brevets

(11) **EP 2 455 974 A1**

(12) **EUROPEAN PATENT APPLICATION**
published in accordance with Art. 153(4) EPC

(43) Date of publication:
**23.05.2012 Bulletin 2012/21**

(21) Application number: **10813601.1**

(22) Date of filing: **09.08.2010**

(51) Int Cl.:
*H01L 29/786* (2006.01)    *G02F 1/1368* (2006.01)
*G09F 9/30* (2006.01)    *H01L 21/28* (2006.01)
*H01L 21/8234* (2006.01)    *H01L 27/088* (2006.01)
*H01L 29/423* (2006.01)    *H01L 29/49* (2006.01)

(86) International application number:
**PCT/JP2010/063463**

(87) International publication number:
**WO 2011/027650 (10.03.2011 Gazette 2011/10)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **01.09.2009 JP 2009201368**

(71) Applicant: **Sharp Kabushiki Kaisha Osaka-shi, Osaka 545-8522 (JP)**

(72) Inventor: **KITAKADO, Hidehito Osaka 545-8522 (JP)**

(74) Representative: **Müller - Hoffmann & Partner Patentanwälte Innere Wiener Strasse 17 81667 München (DE)**

(54) **SEMICONDUCTOR DEVICE, ACTIVE MATRIX SUBSTRATE, AND DISPLAY DEVICE**

(57)    Provided are a semiconductor device that can be fabricated easily and can achieve leakage current reduction, without its structure becoming complex or the device becoming bulky an active matrix substrate in which the device is used; and a display device in which the device is used. A switching portion (18) (semiconductor device) provided with thin film transistors (Tr1, Tr2) having a top gate electrodes (g1, g2) (main gate electrodes) and a bottom gate electrode (21) (auxiliary gate electrode) includes a silicon layer (SL) (semiconductor layer) provided between the top gate electrodes (g1, g2) and the bottom gate electrode (21); and a light shielding film that shields a carrier generation region formed in the silicon layer from light. A potential of the top gate electrodes (g1, g2) is controlled by a gate signal supplied via a signal line, and a potential of the bottom gate electrode (21) is determined depending on capacity coupling between the bottom gate electrode (21) and the top gate electrodes (g1, g2).

F I G. 3

**Description**

Technical Field

The present invention relates to a semiconductor device provided with transistors, an active matrix substrate in which such a semiconductor device is used, and a display device in which such a semiconductor device is used.

Background Art

Recently, a liquid crystal display device, for example, has been used as a flat panel display characterized in thinness, light weight, etc. as compared with a conventional cathode-ray tube, widely in liquid crystal televisions, monitors, portable telephones, etc. In such a liquid crystal display device, a plurality of data lines (source lines) and a plurality of scanning lines (gate lines) are arranged in matrix. Besides, the liquid crystal display device includes an active matrix substrate in which switching elements such as thin film transistors (hereinafter abbreviated as "TFT") located in the vicinity of intersections between the data lines and the scanning lines, and pixels having pixel electrodes connected to the switching elements, are arranged in matrix.

In the active matrix substrate, generally, thin film transistors for peripheral circuits are provided integrally, in addition to the above-described pixel-driving thin film transistors as switching elements. Further, in the case where the active matrix substrate is used in a touch-panel-equipped liquid crystal display device, or a liquid crystal display device having illuminance sensors (ambient sensors), the active matrix substrate is provided with photodiodes as optical sensors (thin film diodes: TFDs) additionally. Thus, the active matrix substrate includes a plurality of semiconductor devices that are provided with thin film transistors, photodiodes, and the like.

Recently, in a liquid crystal panel incorporating optical sensors, a liquid crystal panel incorporating pixel memories, etc. as described above, the reduction of a leakage current of a thin film transistor (transistor) has been attempted, so as to meet the request for the reduction of power consumption. More specifically, as a structure for suppressing a leakage current of a transistor, an LDD structure is known in which a low-concentration impurity-doped region (LDD region: lightly doped drain region) having a higher resistance than in a source region and a drain region may be provided in at least one of the following two regions: a region between a channel region and the source region; and a region between the channel region and the drain region. Further, a configuration in which a transistor is provided with a light shielding film so that illumination light from a backlight device should not enter the transistor, whereby flow of a light leakage current is suppressed has been proposed (see, for example, JP2003-8026A).

In the configuration in which a transistor is provided with a light shielding film as described above, in the case where the light shielding film is formed by a conductive material such a metal, the light shielding film assumes a state of floating electrically (floating state). Then, the light shielding film is capacitively coupled with a drain region of a transistor, and the potential of the light shielding film fluctuates, whereby a leakage current flows. In other words, even if a gate voltage is 0 V, a leakage current flows in some cases, depending on the potential of the light shielding film.

To cope with this, it has been proposed to use a transistor having a double gate structure for applying a voltage to the light shielding film, as disclosed in, for example, JP2002-57341A. In this transistor having the double gate structure, a usual gate electrode is a top gate electrode, and a light shielding film made of a conductive material is a bottom gate electrode. Then, by applying voltages to the top gate electrode and the bottom gate electrode, the bottom gate electrode (light shielding film) is prevented from assuming the floating state, whereby the occurrence of the leakage current is suppressed.

Disclosure of Invention

With the configuration as disclosed in JP2002-57341A, however, the structure of the semiconductor device becomes complex, the device as a whole becomes bulky, and the steps needed for fabrication increase.

More specifically, in the case of the aforementioned configuration, since voltages are applied to the top gate electrode and the bottom gate electrode, it is necessary to form lines for supplying voltages to the top gate electrode and the bottom gate electrode.

Further, in the case of the aforementioned configuration, it is necessary to form a contact hole excessively used for the bottom gate electrode. Moreover, it is necessary to perform the formation of the contact hole, separately from the formation of contact holes for a source region and a drain region included in a semiconductor layer (silicon layer) of a transistor. In other words, in the case of the aforementioned configuration in which the bottom gate electrode is located on the substrate side as compared with the semiconductor layer of the transistor, if the contact hole for the bottom gate electrode and the contact holes for the source region and the drain region are formed at the same time, a base insulation film between the bottom gate electrode and the source region as well as the drain region is etched unnecessarily. This leads to a possibility that the base insulation film could be pierced, etc.

It is an object of the present invention to obtain a configuration of a semiconductor device that can achieve leakage current reduction and that can be fabricated easily, without making its structure complex or making the device bulky.

A semiconductor device according to one embodiment of the present invention is a semiconductor device provided with a transistor having a main gate electrode and an auxiliary gate electrode, and the semiconductor device includes:

a semiconductor layer provided between the main gate electrode and the auxiliary gate electrode; and
a light shielding film that shields one side of a carrier generation region formed in the semiconductor layer from light,
wherein a potential of the main gate electrode is controlled by a gate signal supplied via a signal line connected to the main gate electrode, and
a potential of the auxiliary gate electrode is determined depending on capacity coupling between the auxiliary gate electrode and the main gate electrode.

The above-described embodiment makes it possible to obtain a configuration of a semiconductor device that can achieve leakage current reduction and that can be fabricated easily, without making its structure complex or making the device bulky

Brief Description of Drawings

[FIG. 1] FIG. 1 is a cross-sectional view showing a configuration of a liquid crystal display device according to Embodiment 1.
[FIG. 2] FIG. 2 schematically shows a configuration of a liquid crystal panel shown in FIG. 1.
[FIG. 3] FIG. 3 is a circuit diagram showing an equivalent circuit of a switching portion shown in FIG. 2.
[FIG. 4] FIG. 4 is a plan view showing a schematic configuration of principal parts of the switching portion.
[FIG. 5] FIGS. 5(a) and 5(b) are cross-sectional views taken along lines Va-Va and Vb-Vb in FIG. 4, respectively.
[FIG. 6] FIG. 6 is a graph showing the relationship between a terminal voltage of a top gate electrode and a potential of a bottom gate electrode in the case where a capacitance ratio of parts in the switching portion is changed.
[FIG. 7] FIG. 7 is a graph showing the relationship between a potential of a bottom gate electrode and a resistance value of a low-concentration impurity-doped region in the switching portion.
[FIG. 8] FIG. 8 is a plan view showing a schematic configuration of principal parts of a switching portion according to Embodiment 2.
[FIG. 9] FIG. 9 is a cross-sectional view taken along a line IX-IX in FIG. 8.
[FIG. 10] FIG. 10 is a circuit diagram showing an equivalent circuit of a switching portion according to embodiment 3.
[FIG. 11] FIG. 11 is a plan view showing a schematic configuration of principal parts of the switching portion shown in FIG. 10.
[FIG. 12] FIGS. 12 (a) and 12(b) are cross-sectional views taken along lines XIIa-XIIa and XIIb-XIIb in FIG. 11, respectively.
[FIG. 13] FIG. 13 is a circuit diagram showing an equivalent circuit of a switching portion according to Embodiment 4.
[FIG. 14] FIG. 14 is a plan view showing a schematic configuration of principal parts of the switching portion shown in FIG. 13.
[FIG. 15] FIGS. 15(a) and 15(b) are cross-sectional views taken along lines XVa-XVa and XVb-XVb in FIG. 14, respectively.
[FIG. 16] FIG. 16 is a plan view showing a schematic configuration of principal parts of a switching portion according to Embodiment 5.
[FIG. 17] FIGS. 17(a) and 17(b) are cross-sectional views taken along lines XVIIa-XVIIa and XVIIb-XVIIb in FIG. 16, respectively.

Description of the Invention

A semiconductor device according to one embodiment of the present invention is a semiconductor device provided with a transistor having a main gate electrode and an auxiliary gate electrode, and the semiconductor device includes:

a semiconductor layer provided between the main gate electrode and the auxiliary gate electrode; and
a light shielding film that shields one side of a carrier generation region formed in the semiconductor layer from light,

wherein a potential of the main gate electrode is controlled by a gate signal supplied via a signal line connected to the main gate electrode, and
a potential of the auxiliary gate electrode is determined depending on capacity coupling between the auxiliary gate electrode and the main gate electrode (first configuration).

Since the above-described configuration allows a potential of the auxiliary gate electrode to be determined by a capacitance between the auxiliary gate electrode and the main gate electrode, there is no need to connect a line to the auxiliary gate electrode to control the potential of the auxiliary gate electrode. Therefore, the configuration of the semiconductor device is made simpler for this, which makes it possible to fabricate the semiconductor device easily. As a result, a configuration that can be fabricated easily can be obtained for a semiconductor device that can achieve leakage current reduction, without the structure becoming complex or the device becoming bulky.
The above-described first configuration may be modified in the following manner:

the transistor is formed on a substrate,
the main gate electrode is formed with a top gate electrode provided on a side opposite to the substrate with respect to the semiconductor layer, and
the auxiliary gate electrode is formed with a bottom gate electrode provided on a side toward the substrate with respect to the semiconductor layer (second configuration).

In this case, the potential of the top gate electrode is controlled by a gate signal supplied via the signal line connected to the top gate electrode, and the potential of the bottom gate electrode is determined depending on the capacity coupling between the bottom gate electrode and the top gate electrode.
Further, in the second configuration, the bottom gate electrode is preferably used as the light shielding film (third configuration).
This makes it possible to prevent the structure of the semiconductor device from becoming complex, or to prevent the device from becoming bulky, as well as to fabricate the semiconductor device easily.
Further, in any one of the first to third configurations, preferably, the transistor is an N-type transistor, and a terminal voltage of the transistor, and a capacitance formed between the main gate electrode and the auxiliary gate electrode are set so that the auxiliary gate electrode has a negative potential in the case where the main gate electrode has a potential that causes the transistor to be in an OFF state (fourth configuration).
Alternatively, the transistor may be a P-type transistor, and a terminal voltage of the transistor, and a capacitance formed between the main gate electrode and the auxiliary gate electrode may be set so that the auxiliary gate electrode has a positive potential in the case where the main gate electrode has a potential that causes the transistor to be in an OFF state (fifth configuration).
With these configurations, the transistor is caused to be in an OFF state. Thus, the above-described configurations make it possible to make the generated leakage current equivalent to a leakage current in a state where an auxiliary gate electrode is not provided and there is no light irradiation.
Further, in any one of the first to fifth configurations, the semiconductor layer may include a channel region, a low-concentration impurity-doped region, and a high-concentration region, the low-concentration impurity-doped region, a part of the high-concentration region, and a part of the channel region on a high-concentration region side may fall in the carrier generation region, and the light shielding film may be provided so as to be positioned on one side of the carrier generation region (sixth configuration).
This makes it possible to prevent light from entering the carrier generation region, thereby enabling leakage current reduction.
Further, in any one of the first to fifth configurations, the semiconductor layer may include an offset region and a high-concentration region, the offset region and a part of the high-concentration region may fall in the carrier generation region, and the light shielding film may be provided so as to be positioned on one side of the carrier generation region (seventh configuration).
This makes it possible to prevent light from entering the carrier generation region, thereby enabling leakage current reduction.
Further, in any one of the first to seventh configurations, a transistor with top gate structure is preferably connected in series to the transistor having the main gate electrode and the auxiliary gate electrode (eighth configuration).
This makes it possible to decrease a source/drain voltage per one transistor, thereby suppressing a leakage current.
Further, in the eighth configuration, among the plurality of transistors connected in series, the transistor to which a drain voltage is applied from outside may be the transistor with top gate structure (ninth configuration).

This makes it possible to suppress fluctuations of the potential of the auxiliary gate electrode due to influences of the drain voltage in a state where the transistor is turned off.

Further, in an active matrix substrate according to one embodiment of the present invention, the semiconductor device according to any one of the first to ninth configurations is used (tenth configuration).

This makes it possible to easily obtain an active matrix substrate that is compact and that achieves low power consumption.

In a display device according to one embodiment of the present invention, the semiconductor device according to any one of the first to ninth configurations is used (eleventh configuration).

This makes it possible to easily obtain a display device that is compact and that achieves low power consumption.

Hereinafter, preferable embodiments of the semiconductor device, the active matrix substrate, and the display device are explained with reference to drawings. It should be noted that in the following explanation, the present invention is explained by referring to an exemplary case where an embodiment of the present invention is applied to a pixel-driving switching portion used in an active matrix substrate. Dimensions of constituent members shown in the drawings do not necessarily faithfully show dimensions of actual constituent members, dimension ratios of the actual constituent members, and the like.

[Embodiment 1]

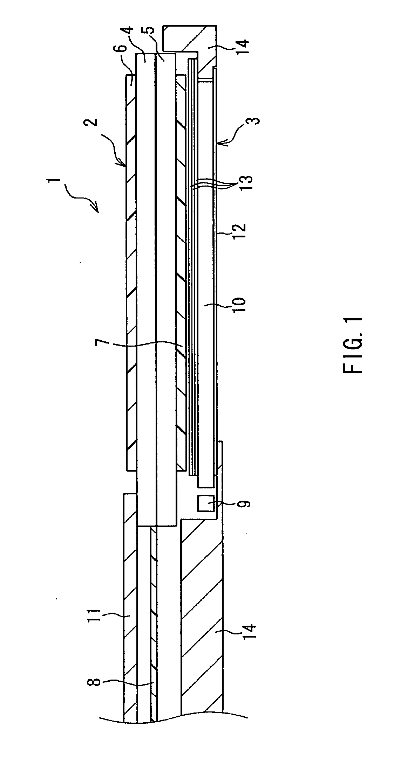

FIG. 1 is a cross-sectional view showing a configuration of a liquid crystal display device according to Embodiment 1. A liquid crystal display device 1 shown in FIG. 1 includes a liquid crystal panel 2 provided so that a viewed side thereof (display surface side) is the upper side as viewed in FIG. 1, and a backlight device 3 that is provided on a non-display surface side (lower side as viewed in FIG. 1) of the liquid crystal panel 2 and that irradiates the liquid crystal panel 2 with illumination light.

The liquid crystal panel 2 includes a color filter substrate 4 and an active matrix substrate 5 that composes a pair of substrates, and polarization plates 6 and 7 that are provided on outer side surfaces of the color filter substrate 4 and the active matrix substrate 5, respectively. Between the color filter substrate 4 and the active matrix substrate 5, a liquid crystal layer is interposed, though the illustration of the liquid crystal layer is omitted. A plate-like transparent glass material, or a transparent synthetic resin such as an acrylic resin, is used for forming the color filter substrate 4 and the active matrix substrate 5. Films of resins, such as TAC (triacetyl cellulose), or PVA (polyvinyl alcohol) are used for the polarization plates 6 and 7. The polarization plates 6 and 7 are attached over the color filter substrate 4 and the active matrix substrate 5, respectively, so as to cover at least an effective display region on the display surface provided on the liquid crystal panel 2.

The active matrix substrate 5 forms one of the above-described pair of substrates. Pixel electrodes, thin film transistors (TFT), etc. are provided on the active matrix substrate 5, so as to correspond to a plurality of pixels included in the display surface of the liquid crystal panel 2 (details are to be described later). On this active matrix substrate 5, as will be described later in detail, a switching portion (semiconductor device) of the present embodiment that includes the aforementioned thin film transistor is provided for each pixel. On the other hand, the color filter substrate 4 forms the other one of the pair of substrates. On the color filter substrate 4, color filters, a counter electrode, etc. are formed (not shown).

Further, the liquid crystal panel 2 is provided with a FPC (flexible printed circuit) 8 connected to a control device (not shown) that performs driving control for the liquid crystal panel 2. In the liquid crystal panel 2, the liquid crystal layer is caused to operate pixel by pixel, based on a signal input from the control device via the FPC 8, so as to display an image on the display surface.

It should be noted that the liquid crystal panel 2 may have an arbitrary liquid crystal mode and an arbitrary pixel configuration. Besides, the driving mode of the liquid crystal panel 2 may be arbitrary. In other words, any liquid crystal panel that is capable of displaying characters, images, and the like can be used as the liquid crystal panel 2. Therefore, a detailed structure of the liquid crystal panel 2 is not shown in FIG. 1, and explanation of the same is omitted also.

The backlight device 3 includes a light emitting diode 9 as a light source, and a light guide plate 10 arranged so as to face the light emitting diode 9. In the backlight device 3, the light emitting diode 9 and the light guide plate 10 are held by bezels 14, in a state where the liquid crystal panel 2 is provided above the light guide plate 10. Further, a case 11 is in contact with the color filter substrate 4. In this way, the backlight device 3 is assembled with the liquid crystal panel 2 so as to form a part of the transmissive-type liquid crystal display device 1 in which illumination light from the backlight device 3 is incident on the liquid crystal panel 2.

For the light guide plate 10, a synthetic resin such as a transparent acrylic resin is used, and the light from the light emitting diode 9 enters the light guide plate 10. On a side of the light guide plate 10 opposite to the liquid crystal panel 2 (a facing side), a reflection sheet 12 is provided. On a liquid crystal panel 2 side (a light emission side) of the light guide plate 10, an optical sheet 13 such as a lens sheet or a diffusion sheet is provided. Thus, the light from the light emitting diode 9, guided in a predetermined light guiding direction (a direction from left to right as viewed in FIG.

1) in the light guide plate 10, is converted into the aforementioned illumination light that is planar and has a uniform illuminance, and is given to the liquid crystal panel 2.

It should be noted that the above explanation explains a configuration in which the edge-light-type backlight device 3, having the light guide plate 10, is used, but the present embodiment is not limited to this configuration. A direct-type backlight device may be used. Alternatively, a backlight device having a light source other than a light emitting diode, such as a cold cathode fluorescent tube or a hot cathode fluorescent tube, can be used.

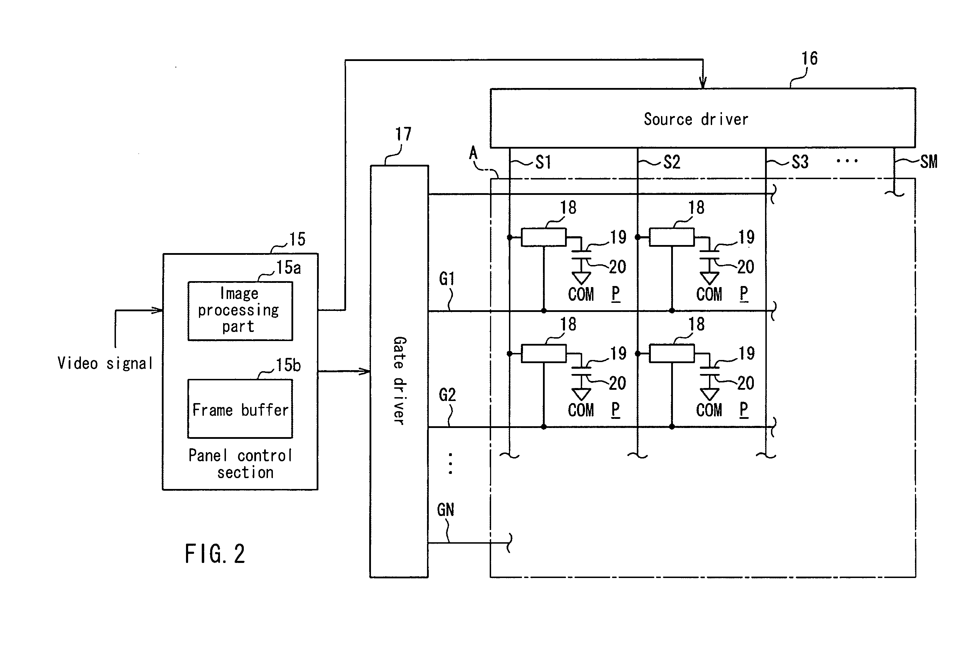

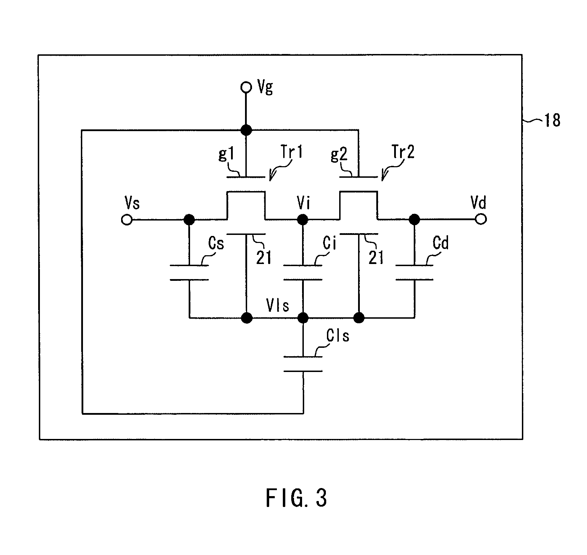

Next, the liquid crystal panel 2 of the present embodiment is explained below specifically, with reference to FIGS. 2 and 3.

FIG. 2 is a schematic view for explaining a configuration inside the liquid crystal panel shown in FIG. 1. FIG. 3 is a circuit diagram showing an equivalent circuit of a switching portion shown in FIG. 2.

In FIG.2, the liquid crystal display device 1 (FIG. 1) is provided with a panel control section 15 that performs driving control of the aforementioned liquid crystal panel 2 (FIG. 1) for displaying characters and images, a source driver 16 and a gate driver 17 that operate based on instruction signals from the panel control section 15.

The panel control section 15 is provided in the control device. To the panel control section 15, video signals are input from outside the liquid crystal display device 1. The panel control section 15 includes an image processing part 15a that performs predetermined image processing with respect to input video signals, and generates respective instruction signals for the source driver 16 and the gate driver 17; and a frame buffer 15b that is capable of storing display data for one frame contained in the video signals that are input therein. The panel control section 15 performs driving control for the source driver 16 and the gate driver 17 based on the video signals input therein, whereby information corresponding to the video signals input therein is displayed on the liquid crystal panel 2.

The source driver 16 and the gate driver 17 are provided on the active matrix substrate 5. More specifically, the source driver 16 is provided on a surface of a base substrate of the active matrix substrate 5, in a region outside an effective display region A of the liquid crystal panel 2, so as to extend in a horizontal direction of the liquid crystal panel 2. The gate driver 17 is provided on a surface of a base substrate of the active matrix substrate 5, in a region outside the effective display region A, so as to extend in a vertical direction of the liquid crystal panel 2.

The source driver 16 and the gate driver 17 are driving circuits for driving a plurality of pixels P of the liquid crystal panel 2, pixel by pixel. To the source driver 16 and the gate driver 17, a plurality of source lines S1 to SM (M is an integer of 2 or more, and the source lines are hereinafter generally denoted by "S") and a plurality of gate lines G1 to GN (N is an integer of 2 or more, and the gate lines are hereinafter generally denoted by "G") are connected, respectively. These source lines S and gate lines G compose data lines and scanning lines, respectively. The source lines S and the gate lines G are provided so as to cross each other on the base substrate (a substrate (not shown) made of a transparent glass material or a transparent synthetic resin) of the active matrix substrate 5, thereby being arranged in matrix. More specifically, the source lines S are provided on the base substrate so as to be in parallel with a column direction of the matrix (the vertical direction of the liquid crystal panel 2), and the gate lines G are provided on the base substrate so as to be in parallel with a row direction of the matrix (the horizontal direction of the liquid crystal panel 2).

The gate lines G also compose signal lines. By supplying a gate signal to the gate lines G, a potential of a top gate electrode, which will be described later, in the above-described switching portion can be controlled.

Further, in the vicinity of each of the intersections between the source lines S and the gate lines G, there are provided a switching portion 18 for a pixel electrode as the semiconductor device according to one embodiment of the present invention, and the aforementioned pixel P having a pixel electrode 19 connected to the switching portion 18. In each pixel P, a common electrode 20 is provided facing the pixel electrode 19, so that the liquid crystal layer 4 is interposed between the common electrode 20 and the pixel electrode 19. In other words, in the active matrix substrate 5, the switching portion 18, the pixel electrode 19, and the common electrode 20 are provided for each pixel.

As shown in FIG. 3, a plurality, for example, two, of thin film transistors Tr1 and Tr2 are connected in series in the switching portion 18. Besides, in the switching portion 18, respective top gate electrodes g1 and g2 of the thin film transistors Tr1 and Tr2 form main gate electrodes. These top gate electrodes g1 and g2 are connected to the gate line G (FIG. 2). Further, a source electrode and a drain electrode of the switching portion 18 are connected to the source line S (FIG. 2) and the pixel electrode 19 (FIG. 2), respectively. Further, in the switching portion 18, a bottom gate electrode 21 as an auxiliary gate electrode is capacitively coupled with the top gate electrodes g1 and g2. Still further, in the switching portion 18, potentials of the top gate electrodes g1 and g2 are controlled by a gate signal from the gate line G, and at the same time, a potential Vls of the bottom gate electrode 21 is determined depending on the capacity coupling with the top gate electrodes g1 and g2.

It should be noted that in FIG. 3, "Vg" indicates a terminal voltage (potential) of the top gate electrodes g1 and g2, and "Vs" and "Vd" indicate a terminal voltage of the source electrode and a terminal voltage of the drain electrode, respectively. "Vi" indicates a potential of a junction point (midpoint) of the thin film transistors Tr1 and Tr2. This "Vi" can be determined approximately by $Vi = (Vd-Vs)/2$ in a state where the thin film transistors Tr1 and Tr2 are turned off. "Cls" indicates an electrostatic capacitor between the top gate electrodes g1 and g2 and the bottom electrode 21. "Cs" indicates an electrostatic capacitor between the bottom gate electrode 21 and a portion on the source electrode side in the silicon layer (described later). "Ci" indicates an electrostatic capacitor between the bottom gate electrode 21 and a portion between the top gate electrodes g1 and g2 in the silicon layer, and "Cd" indicates an electrostatic capacitor between the bottom gate electrode 21 and a portion on the drain electrode side in the silicon layer.

Still further, in the switching portion 18 of the present embodiment, the bottom gate electrode 21, which is one in number, is provided with respect to the two gate electrodes g1 and g2. Further, the bottom gate electrode 21 also functions as a light shielding film for blocking illumination light from the backlight device 3 (details will be described later).

With reference to FIG. 2 again, on the active matrix substrate, regions of a plurality of the pixels P are formed so as to correspond to regions defined in matrix by the source lines S and the gate lines G, respectively. The plurality of pixels P include red (R) pixels, green (G) pixels, and blue (B) pixels. These pixels RGB are arranged, for example, in this order of RGB, in parallel with the gate lines G1 to GN. Further, with a color filter layer (described later) provided on the color filter substrate 4 side, the pixels RGB perform display of corresponding colors.

In response to an instruction signal output from the image processing part 15a, the gate driver 17 outputs, to the gate lines G1 to GN sequentially, a scanning signal (gate signal) that causes the top gate electrodes g1 and g2 in the corresponding switching portion 18 to turn on simultaneously. Further, in response to instruction signals output from the image processing part 15a, the source driver 16 outputs data signals (voltage signals (gray scale voltages)) corresponding to illuminances (gray scale levels) of display images to corresponding ones of the source lines S1 to SM.

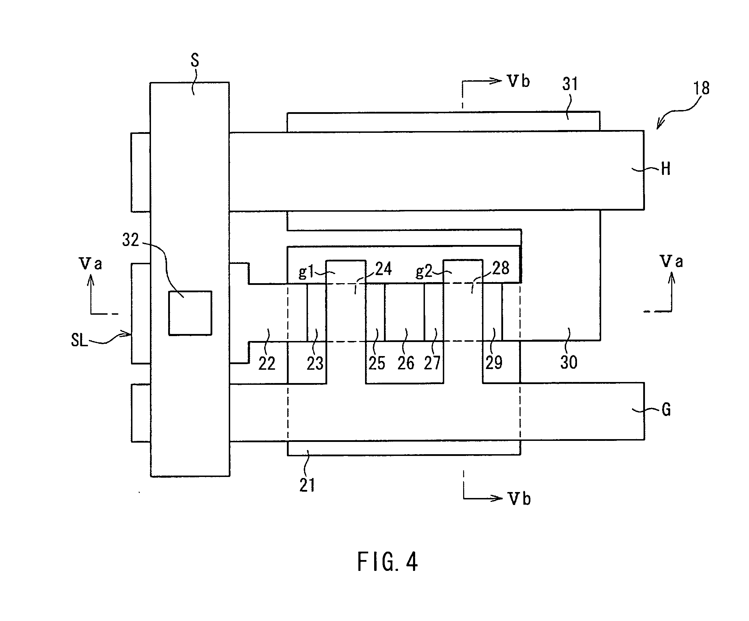

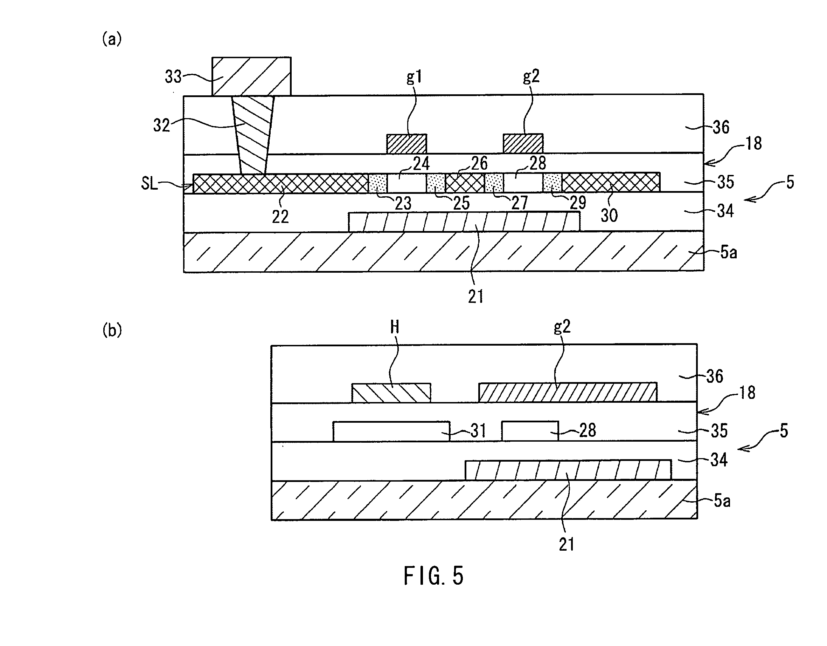

Hereinafter, the configuration of the switching portion 18 is explained specifically, with reference to FIGS. 4, 5 (a), and 5(b).

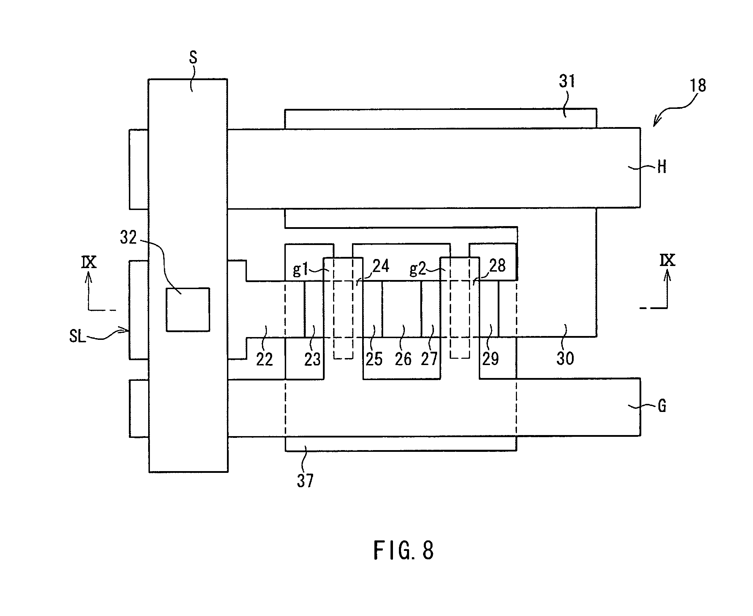

FIG. 4 is a plan view showing a configuration of principal parts of the above-described switching portion. FIGS. 5(a) and 5(b) are cross-sectional views taken along lines Va-Va and Vb-Vb in FIG. 4, respectively. Incidentally, in FIGS. 4, 5(a), and 5(b), the illustration of the drain electrode and the contact holes connected therewith is omitted for simplification of the drawings (this applies to FIGS. 8, 9, 11, 12(a), 12(b), 14, 15(a), 15(b), 16, 17(a), and 17(b) referred to later).

As shown in FIG. 4, in the switching portion 18, a silicon layer SL (semiconductor layer) in an approximate U-letter shape is provided below the top gate electrodes g1 and g2 connected to the gate line G. Below a part of the silicon layer SL, the bottom gate electrode 21 in a rectangular form is provided. This bottom gate electrode 21 is provided so as to overlap the top gate electrodes g1 and g2 in a direction perpendicular to a surface of paper carrying FIG. 4 (in a thickness direction of the active matrix substrate 5). The top gate electrodes g1 and g2, and the bottom gate electrode 21, are capacitively coupled. Besides, a part of the silicon layer SL forms a rectangular region 31 for generation of a retention capacitance. This region 31 is positioned below a retention capacitance electrode line H in parallel with the gate electrode G. This causes a predetermined retention capacitance to be generated.

Further, as shown in FIGS. 5(a) and 5(b), in the active matrix substrate 5, the switching portion 18 is provided for each pixel, on a substrate main body 5a made of, for example, a glass substrate. In this switching portion 18, the bottom gate electrode 21 is formed on the substrate main body 5a. Further, in the switching portion 18, a base insulation film 34 is formed so as to cover the bottom gate electrode 21 and the substrate main body 5a, and the silicon layer SL is provided on this base insulation film 34. Still further, in the switching portion 18, a gate insulation film 35 is formed so as to cover the silicon layer SL and the base insulation film 34, and the top gate electrodes g1 and g2 are formed on this gate insulation film 35.

Still further, in the switching portion 18, an interlayer insulation film 36 is formed so as to cover the top gate electrodes g1 and g2, as well as the gate insulation film 35. On this interlayer insulation film 36, a source electrode 33 connected to the source line S (FIG. 4) is formed. This source electrode 33 is connected to the source region 22 provided in the silicon layer SL via a contact hole 32 that pierces the interlayer insulation film 36 and the gate insulation film 35.

Further, in the switching portion 18, N-type transistors are used for the thin film transistors Tr1 and Tr2. In other words, in the silicon layer SL, there are provided: a source region 22, a high-concentration region 26, and a drain region 30 to which an N-type impurity, for example, phosphorus, is doped at a high concentration (indicated by cross-hatching in FIG. 5 (a)); low-concentration impurity-doped regions (LDD regions: lightly doped drain regions, indicated by stippling in FIG. 5(a)) 23, 25, 27, and 29 to which an N-type impurity is doped at a low concentration; and channel regions 24 and 28 provided immediately below the top gate electrodes g1 and g2, respectively. It should be noted that to the drain region 30, a drain electrode is connected, via a contact hole (not shown).

Still further, in the switching portion 18, a non-transparent electrode material is used for forming the bottom gate electrode 21, as will be described in detail later. The bottom gate electrode 21 is configured so as to also function as a light shielding film for preventing light from a bottom side as viewed in FIG. 5, for example, illumination light from the backlight device 3, from entering the low-concentration impurity-doped regions 23, 25, 27, and 29 as well as the channel regions 24 and 28. Thus, in the switching portion 18, a light leakage current due to the illumination light can be suppressed.

Still further, in the switching portion 18, the aforementioned capacitor Cls is formed with a part of the base insulation film 34 and a part of the gate insulation film 35 positioned between the top gate electrodes g1 and g2 and the bottom gate electrode 21 (i.e., parts where the silicon layer SL is not interposed). Further, the aforementioned capacitor Cs is formed with a part of the base insulation film 34 positioned between the bottom gate electrode 21 and a part of the source electrode 22 as well as the low-concentration impurity-doped region 23. The aforementioned capacitor Ci is formed with a part of the base insulation film 34 positioned between the bottom gate electrode 21 and the low-concentration impurity-doped regions 25 and 27 as well as the high-concentration region 26. The aforementioned capacitor Cd is formed with a part of the base insulation film 34 positioned between the bottom gate electrode 21 and the low-concentration impurity-doped region 29 as well as a part of the drain region 30.

Respective terminal voltages Vs and Vd of the thin film transistors Tr1 and Tr2, the potential Vi, and respective values of the capacitors Cls, Cs, Ci, and Cd are set so that the bottom gate electrode 21 has a potential Vls of a negative value when a terminal voltage (potential) Vg of the top gate electrodes g1 and g2 is a potential that causes the thin film transistors Tr1 and Tr2 to be in an OFF state. By doing so, in the switching portion 18 of the present embodiment, the thin film transistors Tr1 and Tr2 are caused to be in an OFF state, whereby a light leakage current can be made 0. In other words, the above-described configuration makes it possible to make the leakage current identical to that in the case where light is not projected in a configuration in which the bottom gate electrode 21 is not provided. Therefore, the generation of a leakage current can be suppressed (details will be described later).

Further, in the switching portion 18, a current driving power (i.e., ON current) of the switching portion 18 can be increased by applying a potential to the bottom gate electrode 21 when the thin film transistors Tr1 and Tr2 are in an ON state (details will be described later).

Here, the following description specifically explains a method for fabricating the switching portion 18.

A film of a metal such as molybdenum or tungsten is formed by sputtering on the substrate main body 5a as viewed in FIGS. 5(a) and 5(b). Thereafter, patterning is carried out by photolithography and etching, whereby the bottom gate electrode 21 is formed. This bottom gate electrode 21 has a film thickness of, for example, about 100 to 200 nm.

Next, as the base insulation film 34, for example, an SiN film and an $SiO_2$ film are sequentially formed by CVD (chemical vapor deposition) so as to have a film thickness of 100 nm each. Thereafter, an amorphous silicon film is formed on the base insulation film 34 so as to have film thickness of 50 nm, and is crystallized by laser so as to become polysilicon. This polysilicon is doped with boron as a channel dope for threshold adjustment.

Then, an $SiO_2$ film is formed as the gate insulation film 35 on the polysilicon so as to have a film thickness of 80 nm. Thereafter, a film of a metal such as molybdenum or tungsten is formed on the gate insulation film 35, and patterning is carried out, whereby the top gate electrodes g1 and g2 are formed. Using these top gate electrodes g1 and g2 as a mask, an N-type impurity, for example, phosphorus, is doped at a low concentration into the polysilicon, whereby the low-concentration impurity-doped regions 23, 25, 27, and 29 are formed. Then, after a photoresist is formed for ensuring a longitudinal dimension (LDD length) of the low-concentration impurity-doped regions 23, 25, 27, and 29, phosphorus is doped in order to form the source region 22, the high-concentration region 26, and the drain region 30.

Here, in the low-concentration impurity-doped regions 23, 25, 27, and 29, a doping amount is adjusted so that the regions have a sheet resistance of about 50 kΩ to 150 kΩ (for example, the doping amount is $1 \times 10^{13}$ to $1 \times 10^{14}$ /cm$^2$). The doping is performed at a doping amount adjusted so as to counteract the previously doped P-type impurity (boron) for a channel dope. Thus, the N-type low-concentration impurity-doped regions 23, 25, 27, and 29 are formed. In the source region 22, the high-concentration region 26, and the drain region 30, phosphorous is doped at an amount of about $1 \times 10^{15}$ /cm$^2$ so that these regions have a sheet resistance of 1 kΩ or less. Thereafter, in order to activate impurities, a heat treatment at 500°C to 600°C is performed for one hour. It should be noted that in order to shorten the heat treatment time, a heat treatment at 650°C to 700°C may be carried out for several minutes by, for example, a lamp annealing device.

Next, as the interlayer insulation film 36, an $SiO_2$ film and an SiN film are formed to a thickness of about 100 nm to 300 nm each. Thereafter, the contact hole 32 and a contact hole (not shown) for connection with the source electrode 33 and the drain electrode (not shown), respectively, are formed therein, and also, a metal film (e.g., Al or an alloy of the same) for the source electrode 23, the drain electrode, and lines is formed, and patterning is carried out.

Finally, though not illustrated in the drawings, a flattening film is formed with a resin film or the like, after the aforementioned lines are formed, and a transparent electrode (e.g., ITO) that will become the pixel electrode 19 is formed thereon. In some cases, a reflection electrode is formed with Al, Ag, or an ally of the same on the ITO.

The above description explains a forming method in the case where the thin film transistors Tr1 and Tr2 are formed with N-type transistors. In the case where the thin film transistors Tr1 and Tr2 are formed with P-type transistors, a P-type impurity, for example, boron, is used as an impurity used for forming the source region 22 and the drain region 30. Besides, since driver circuits in the peripheral area around the panel can be formed also by the above-described forming method, the switching portion 18 of the present structure can be adopted to a switching element in which leakage current reduction is required.

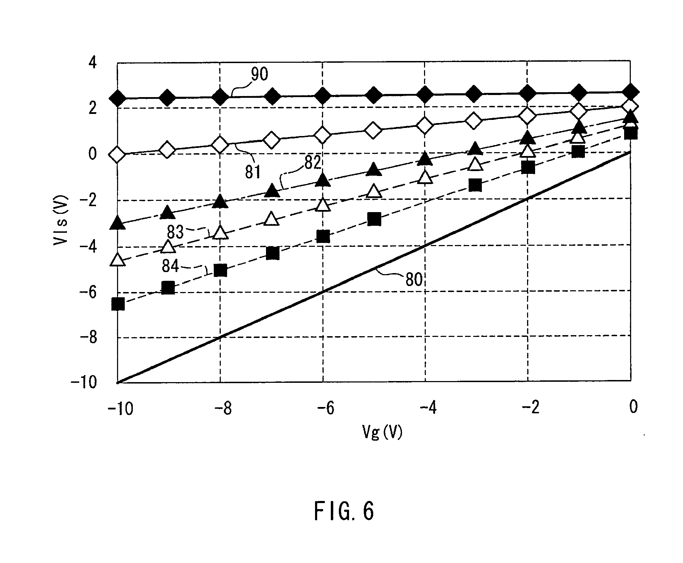

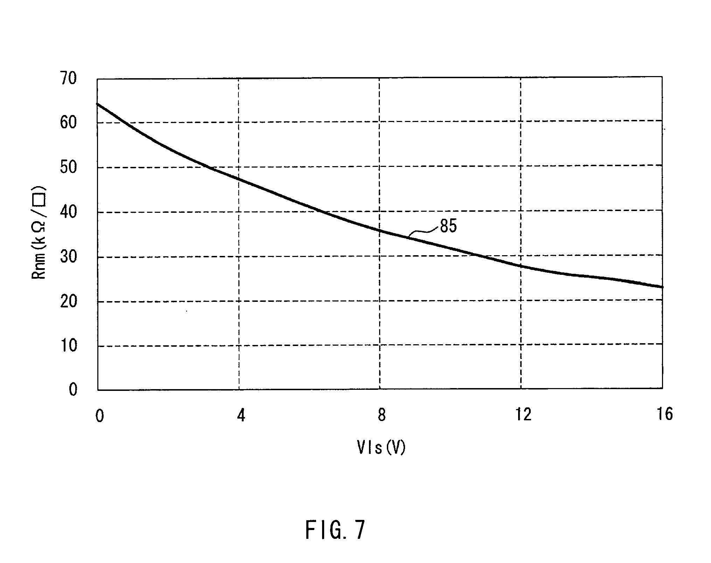

The following specifically explains an effect of the leakage current reduction and the ON current increase in the switching portion 18, referring to FIGS. 6 and 7.

FIG. 6 is a graph showing the relationships between the terminal voltage Vg of the top gate electrode and the potential Vls of the bottom gate electrode in cases of different capacitance ratios of parts of the switching portion. FIG. 7 is a graph showing the relationship between a potential Vls of the bottom gate electrode and a resistance value Rnm of the low-concentration impurity-doped region in the switching portion.

Regarding the switching portion 18 of the present embodiment, in the equivalent circuit shown in FIG. 3, the potential Vls of the bottom gate electrode 21 in the case where the thin film transistors Tr1 and Tr2 are in an OFF state is determined by the formula (1) shown below:

$$Vls = (Vg{\times}Cls+Vs{\times}Cs+Vi{\times}Ci+Vd{\times}Cd) / (Cls+Cs+Ci+Cd) \quad ---- (1)$$

Here, capacitances Cls, Cs, Ci, and Cd are determined by the sizes of the thin film transistors Tr1 and Tr2. Therefore, by deciding the terminal voltages Vg, Vs, and Vd as well as deciding the potential Vi (=(Vd-Vs)/2), the potential Vls of the bottom gate electrode 21 can be determined. Besides, as described above, the respective values of the terminal voltages Vs and Vd, the potential Vi, and the capacitances Cls, Cs, Ci, and Cd are set so that the bottom gate electrode 21 has a potential Vls of a negative value in the case where the terminal voltage (potential) Vg of the top gate electrodes g1 and g2 is a potential that causes the thin film transistors Tr1 and Tr2 to be in an OFF state. In other words, by setting the ratio between the capacitance Cls and the capacitances Cs, Ci, and Cd, the potential Vls of the bottom gate electrode 21 is made a negative potential (Vls<0V).

More specifically, for example, by setting each of the capacitances Cs, Ci, and Cd to 1 and varying the value of the capacitance Cls with respect to the Cs, Ci, and Cd, the potential Vls of the bottom gate electrode 21 can be determined. More specifically, by varying the ratios between the capacitance Cls and the capacitances Cs, Ci, and Cd as indicated by the straight lines 81, 82, 83, and 84 in FIG. 6, the potential Vls of the bottom gate electrode 21 can be set to a negative value. It should be noted that the relationships between the terminal voltage Vg of the top gate electrodes g1 and g2 and the potential Vls of the bottom gate electrode 21 shown in FIG. 6 are results of calculation performed by assuming that a source/drain voltage Vds per one thin film transistor is 5 V The straight line 80 in FIG. 6 is a straight line indicative of a relationship between the terminal voltage Vg itself of the top gate electrodes g1 and g2 and Vls, and the straight line 90 in FIG. 6 is indicative of a conventional example in which a constant potential is applied to the bottom gate electrode, irrespective of the terminal voltage Vg.

For details, in the case where the ratio between the capacitance Cs (= Ci = Cd) and the capacitance Cls is set to 1:1, the potential Vls of the bottom gate electrode 21 varies with respect to the terminal voltage Vg of the top gate electrodes g1 and g2, in the manner as indicated by the straight line 81 in FIG. 6. In this case, when the terminal voltage Vg of the top gate electrodes g1 and g2 is set to -10 V, the potential Vls of the bottom gate electrode 21 can be set to less than 0 V (negative potential).

In the case where the ratio between the capacitance Cs (= Ci = Cd) and the capacitance Cls is set to 1:3, the potential Vls of the bottom gate electrode 21 varies with respect to the terminal voltage Vg of the top gate electrodes g1 and g2, in the manner as indicated by the straight line 82 in FIG. 6. In this case, when the terminal voltage Vg of the top gate electrodes g1 and g2 is set to -3 V or less, the potential Vls of the bottom gate electrode 21 can be set to less than 0 V

In the case where the ratio between the capacitance Cs (= Ci = Cd) and the capacitance Cls is set to 1:5, the potential Vls of the bottom gate electrode 21 varies with respect to the terminal voltage Vg of the top gate electrodes g1 and g2, in the manner as indicated by the straight line 83 in FIG. 6. In this case, when the terminal voltage Vg of the top gate electrodes g1 and g2 is set to -2 V, the potential Vls of the bottom gate electrode 21 can be set to less than 0 V

In the case where the ratio between the capacitance Cs (= Ci = Cd) and the capacitance Cls is set to 1:10, the potential Vls of the bottom gate electrode 21 varies with respect to the terminal voltage Vg of the top gate electrodes g1 and g2, in the manner as indicated by the straight line 84 in FIG. 6. In this case, when the terminal voltage Vg of the top gate electrodes g1 and g2 is set to -1 V, the potential Vls of the bottom gate electrode 21 can be set to less than 0 V

Here, the following case is assumed: the terminal voltage Vg of the top gate electrodes g1 and g2 is a potential that causes the thin film transistors Tr1 and Tr2 to be in an OFF state, that is, a minimum value of the terminal voltage Vg is -4 V In this case, the ratio between the capacitance Cs (= Ci =Cd) and the capacitance Cls can be decided based on the straight line 82 shown in FIG. 6. More specifically, in the aforementioned case, the potential Vls of the bottom gate electrode 21 can be set to a negative potential by setting the ratio between the capacitance Cs (= Ci =Cd) and the capacitance Cls to 1 : 3 or more.

As described above, in the switching portion 18 of the present embodiment, the values of capacitances between the top gate electrodes g1 and g2 and the bottom gate electrode 21 (i.e., the respective values of capacitances Cls, Cs, Ci, and Cd) are set depending on the terminal voltage Vg of the top gate electrodes g1 and g2. More specifically, the values of capacitances Cls, Cs, Ci, and Cd are set so that the bottom gate electrode 21 has a potential Vls that causes the thin film transistors Tr1 and Tr2 to be in an OFF state in the case where the signal (application voltage) input to the top gate electrodes g1 and g2 is a potential that causes the thin film transistors Tr1 and Tr2 to be in an OFF state. This makes it possible to cause the thin film transistors Tr1 and Tr2 to be in an OFF state completely, thereby making it possible to realize a configuration that can achieve leakage current reduction.

It should be noted that in the case where the thin film transistors Tr1 and Tr2 are P-type transistors, the terminal voltages and capacitances of respective parts of the thin film transistors Tr1 and Tr2 may be set so that the bottom gate electrode 21 has a potential Vls of a positive value in the case where the potential of the top gate electrodes g1 and g2 is a potential that causes the thin film transistors Tr1 and Tr2 to be in an OFF state. By doing so, it is possible to achieve the same effect as that achieved in the above-described case of the N-type transistors.

Further, in the switching portion 18 of the present embodiment, in the case where the top gate electrodes g1 and g2 has a terminal voltage Vg of a positive value, the resistances of the channel regions 24 and 28, and the resistances of the low-concentration impurity-doped regions 23, 25, 27, and 29 can be decreased, as is the case with double-gate thin film transistors. Therefore, the ON current can be increased. More specifically, as exemplarily shown by the curve 85 in FIG. 7, as the potential Vls of the bottom gate electrode 21 increases, the resistance of the low-concentration impurity-doped regions 23, 25, 27, and 29 decreases significantly. Further more specifically, in the case where the potential Vls is set to 8 V or more, the resistance of the low-concentration impurity-doped regions 23, 25, 27, and 29 can be decreased to half or less as compared with the case where the potential Vls is set to 0 V As a result, in the switching portion 18 of the present embodiment, the ON current can be increased.

In the switching portion (semiconductor device) 18 of the present embodiment having the above-described configuration, the silicon layer (semiconductor layer) is provided between the top gate electrodes (main gate electrodes) g1 and g2, and the bottom gate electrode (auxiliary gate electrode, light shielding film) 21. The bottom gate electrode 21 shields one side (substrate side) of the silicon layer SL from light. Further, the potential of the top gate electrodes g1 and g2 is controlled by the gate signal from the gate line (signal line) G, and the potential of the bottom gate electrode 21 is determined depending on the capacity coupling with the top gate electrodes g1 and g2. Therefore, in the switching portion 18 of the present embodiment, unlike in the above-described conventional example, it is unnecessary to form contact holes for the bottom gate electrode 21. Accordingly, in the present embodiment, the switching portion that can achieve leakage current reduction can be obtained by a simple fabrication method, without the structure thereof becoming complex or bulky.

Further, by using the switching portion (semiconductor device) 18 as described above, the active matrix substrate 5 and the liquid crystal display device (display device) 1 that are characterized by compactness and low power consumption can be configured easily.

[Embodiment 2]

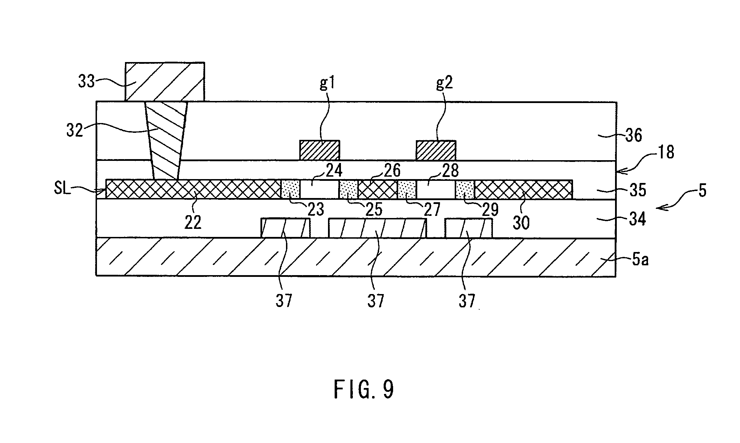

FIG. 8 is a plan view showing a schematic configuration of principal parts of a switching portion according to Embodiment 2. FIG. 9 is a cross-sectional view taken along a line IX-IX in FIG. 8. As shown in the drawings, the main difference of the present embodiment from embodiment 1 is that the bottom gate electrode is not rectangular in shape, but has a comb teeth shape. It should be noted that the elements in common with Embodiment 1 are denoted by the same reference numerals, and repetitive descriptions of the same are omitted.

More specifically, as shown in FIG. 8, in the switching portion 18 of the present embodiment, a bottom gate electrode 37 is formed in a comb teeth shape, and is provided below a carrier generation region where a light leakage current is generated (depleted region, i.e., a region in the vicinity of a drain junction part), which is a region in the silicon layer SL.

More specifically, as shown in FIG. 9, the bottom gate electrode 37 is divided into three pieces, below the silicon layer SL. One piece of the bottom gate electrode 37 is positioned below a part of the source region 22, the low-concentration impurity-doped region 23, and a high-concentration region (source region 22) side part of the channel region 24. The part of the source region 22, the low-concentration impurity-doped region 23, and the high-concentration region (source region 22) side part of the channel region 24, which are mentioned above, form a carrier generation region.

Another piece of the bottom gate 37 is positioned below a high-concentration region 26 side part of the channel region 24, the low-concentration impurity-doped region 25, the high-concentration region 26, the low-concentration impurity-doped region 27, and a high-concentration region 26 side part of the channel region 28. The part of the high-concentration region 26 side part of the channel region 24, the low-concentration impurity-doped region 25, the high-concentration region 26, the low-concentration impurity-doped region 27, and the high-concentration region 26 side part of the channel region 28, which are mentioned above, form a carrier generation region.

Still another piece of the bottom gate electrode 37 is positioned below a high-concentration region (drain region 30) side part of the channel region 28, the low-concentration impurity-doped region 29, and a part of the drain region 30. The high-concentration region (drain region 30) side part of the channel region 28, the low-concentration impurity-doped region 29, and the part of the drain region 30, which are mentioned above, form a carrier generation region.

With the above-described configuration, the same operation and effect as those of Embodiment 1 can be achieved in the present embodiment. Besides, in the present embodiment, since the bottom gate electrode 37 is provided below the above-described carrier generation regions, it is possible to prevent light from entering the carrier generation regions, thereby suppressing the generation of a leakage current.

[Embodiment 3]

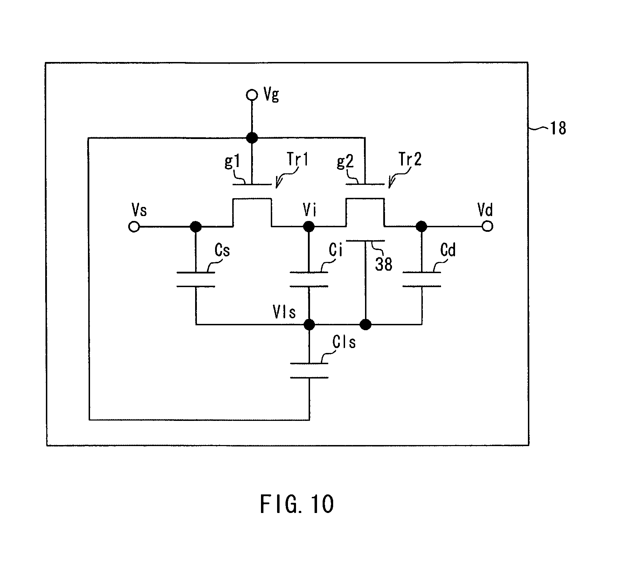

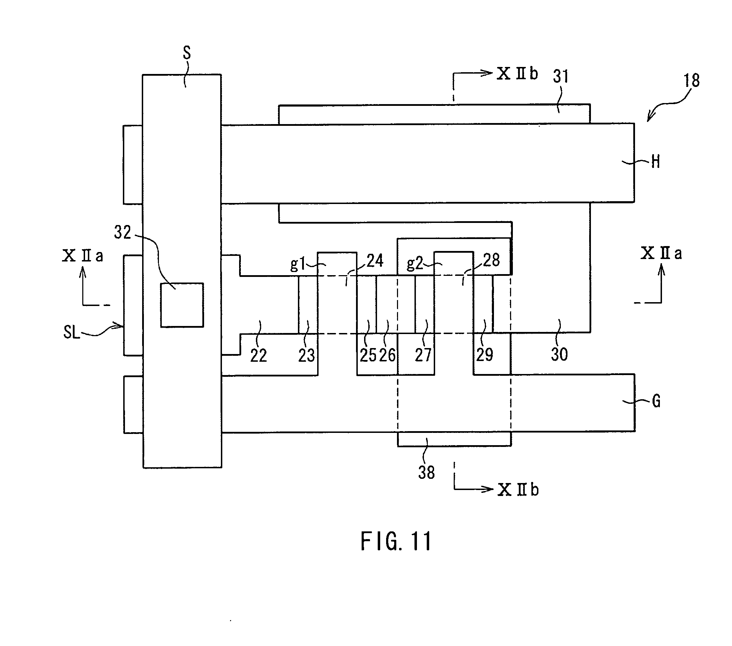

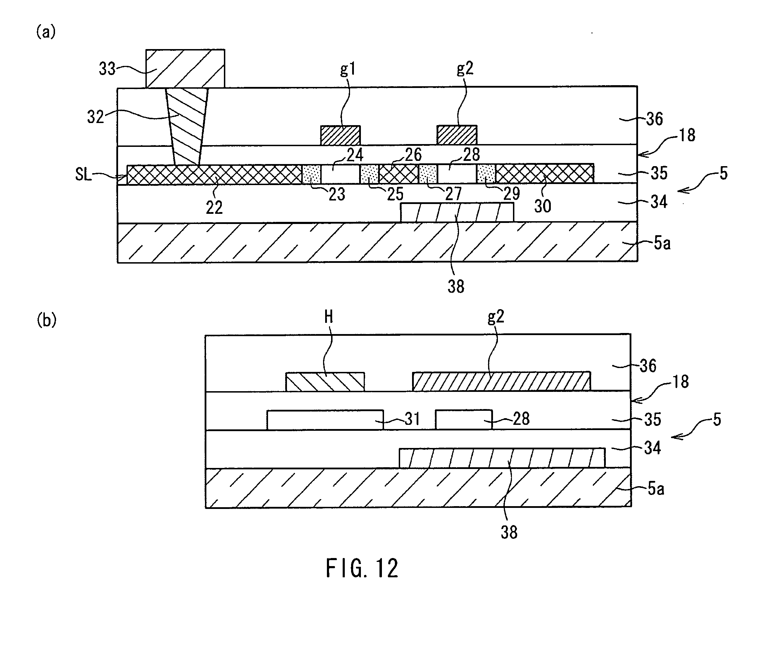

FIG. 10 is a circuit diagram showing an equivalent circuit of a switching portion according to embodiment 3. FIG. 11 is a plan view showing a schematic configuration of principal parts of the switching portion shown in FIG. 10. FIGS. 12(a) and 12(b) are cross-sectional views taken along lines XIIa-XIIa and XIIb-XIIb in FIG. 11, respectively. As shown in the drawings, the main difference of the present embodiment from Embodiment 1 is that a thin film transistor having only a top gate electrode (transistor with top gate structure) is connected in series to a thin film transistor having a top gate electrode (main gate electrode) and a bottom gate electrode (auxiliary gate electrode). It should be noted that the elements in common with Embodiment 1 are denoted by the same reference numerals, and repetitive descriptions of the same are omitted.

More specifically, as shown in FIG. 10, in the switching portion 18 of the present embodiment, a thin film transistor Tr1 having only a top gate electrode g1 (transistor with top gate structure) is connected in series to a thin film transistor Tr2 having a top gate electrode g2 and a bottom gate electrode 38. It should be noted that the thin film transistor Tr1 has only the top gate electrode g1, and hence, it is a transistor with so-called single gate structure.

More specifically, in the switching portion 18 of the present embodiment, as shown in FIGS. 11, 12(a), and 12(b), the bottom gate electrode 38 is provided below the top gate electrode g2, and exclusively below a part of the high-concentration region 26, the low-concentration impurity-doped region 27, the channel region 28, the low-concentration impurity-doped region 29, and a part of the drain region 30.

With the above-described configuration, the same operation and effect as those in Embodiment 1 can be achieved in the present embodiment. Further, in the present embodiment, by connecting the thin film transistors Tr1 and Tr2 in series, a source/drain voltage per one thin film transistor can be reduced, whereby the generation of a leakage current can be suppressed. Still further, with the thin film transistor Tr2 with double gate structure, a decrease in the ON current due to the serial connection can be compensated, whereby a decrease in the ON current can be prevented.

[Embodiment 4]

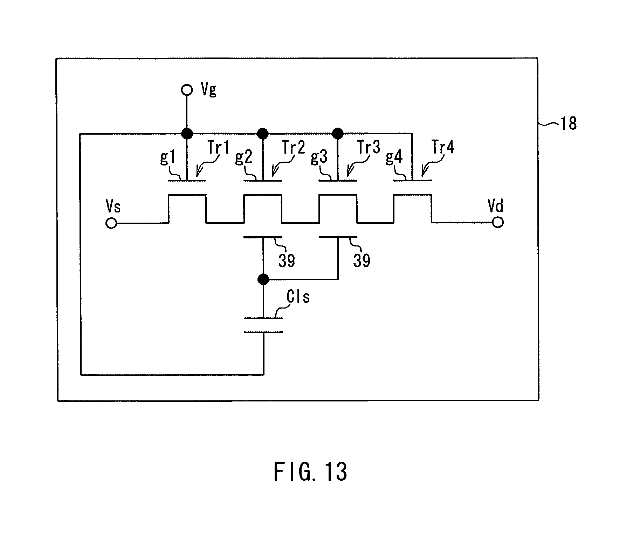

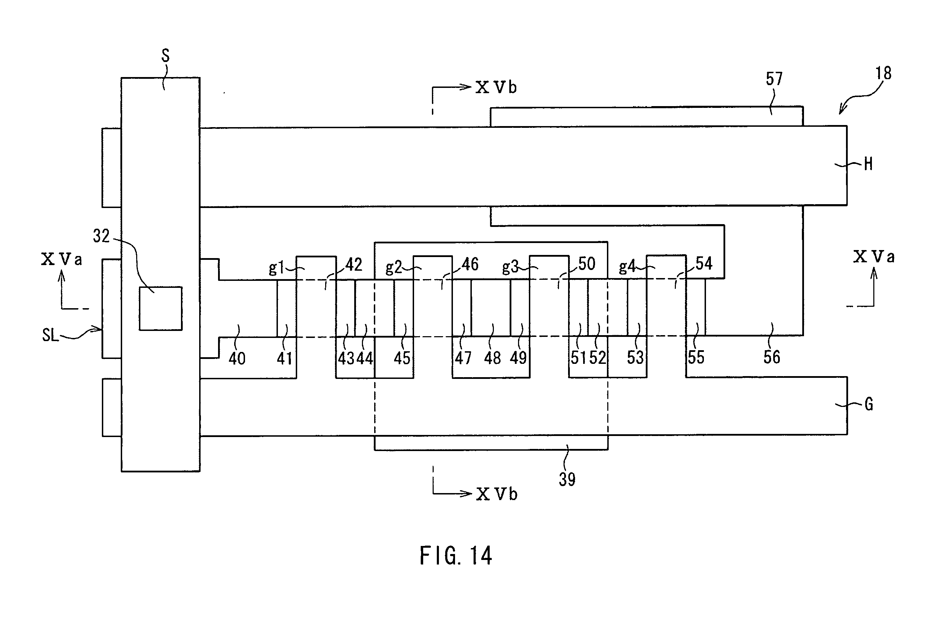

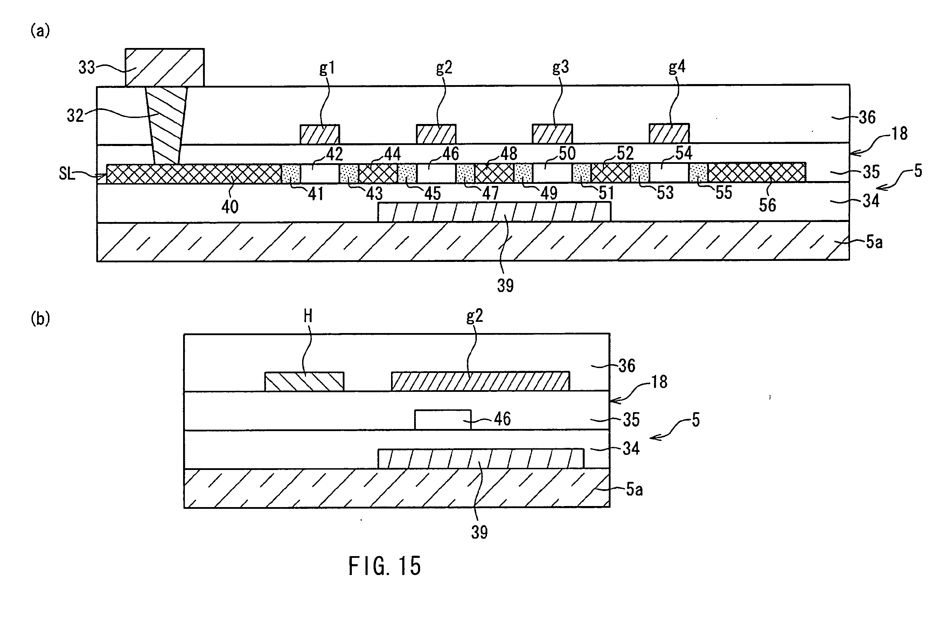

FIG. 13 is a circuit diagram showing an equivalent circuit of a switching portion according to Embodiment 4. FIG. 14 is a plan view showing a schematic configuration of principal parts of the switching portion shown in FIG. 13. FIGS. 15(a) and 15(b) are cross-sectional views taken along lines XVa-XVa and XVb-XVb in FIG. 14, respectively. As shown in the drawings, the main difference of the present embodiment from Embodiment 1 is that a plurality of thin film transistors are connected in series so that a drain voltage is applied from outside to a thin film transistor having only a top gate electrode (transistor with top gate structure). It should be noted that the elements in common with Embodiment 1 are denoted by the same reference numerals, and repetitive descriptions of the same are omitted.

More specifically, as shown in FIG. 13, in the switching portion 18 of the present embodiment, four thin film transistors Tr1, Tr2, Tr3, and Tr4 are connected in series. Besides, thin film transistors Tr1 and Tr4 having only top gate electrodes g1 and g4, respectively (transistors with top gate structure) are used for thin film transistors on the sides to which a drain voltage is applied from outside, that is, thin film transistors at both ends that are connected to the source electrode and the drain electrode, respectively. It should be noted that the reason why the thin film transistors Tr1 and Tr4 of the same type are used for the thin film transistors at both ends is that the source electrode and the drain electrode could possibly be switched with each other. The thin film transistors Tr1 and Tr4, having only top gate electrodes, are transistors with so-called single gate structure.

For the thin film transistors in the middle part, thin film transistors with double gate structure are used; that is, thin film transistors Tr2 and Tr3 having top gate electrodes g2 and g3 (main gate electrodes), respectively, and a bottom gate electrode 39 (auxiliary gate electrode) are used.

As shown in FIGS. 14 and 15(a), in the silicon layer SL, there are provided a source region 40, high-concentration regions 44, 48, and 52, and a drain region 56 (indicated by cross-hatching in FIG. 15(a)) to which an N-type impurity, for example, phosphorus, is doped at a high concentration. Besides, in the silicon layer SL, there are provided low-concentration impurity-doped regions (LDD regions: lightly doped drain regions, indicated by stippling in FIG. 15(a)) 41, 43, 45, 47, 49, 51, 53, and 55 to which an N-type impurity is doped at a low concentration. Further, in the silicon layer SL, there are provided P-type channel regions 42, 46, 50, and 54 immediately below top gate electrodes g1, g2, g3, and g4, respectively. It should be noted that to the drain region 56, the drain electrode is connected, via a contact hole (not shown).

Besides, the bottom gate electrode is provided so as to be positioned below the top gate electrodes g2 and g3, and below a part of the high-concentration region 44, the low-concentration impurity-doped region 45, the channel region 46, the low-concentration impurity-doped region 47, the high-concentration region 48, the low-concentration impurity-doped region 49, the channel region 50, the low-concentration impurity-doped region 51, and a part of the high-concentration region 52.

With the above-described configuration, the same operation and effect as those in Embodiment 1 can be achieved in the present embodiment. Further, in the present embodiment, a drain voltage is applied from outside to the thin film transistors Tr1 and Tr4 that have only the top gate electrodes g1 and g4, respectively, among the plurality of thin film transistors Tr1 to Tr4 connected in series. With this, the potential of the bottom gate electrode 39 is prevented from fluctuating due to influences of the drain voltage in a state where the thin film transistors Tr1 and Tr4 are turned off.

[Embodiment 5]

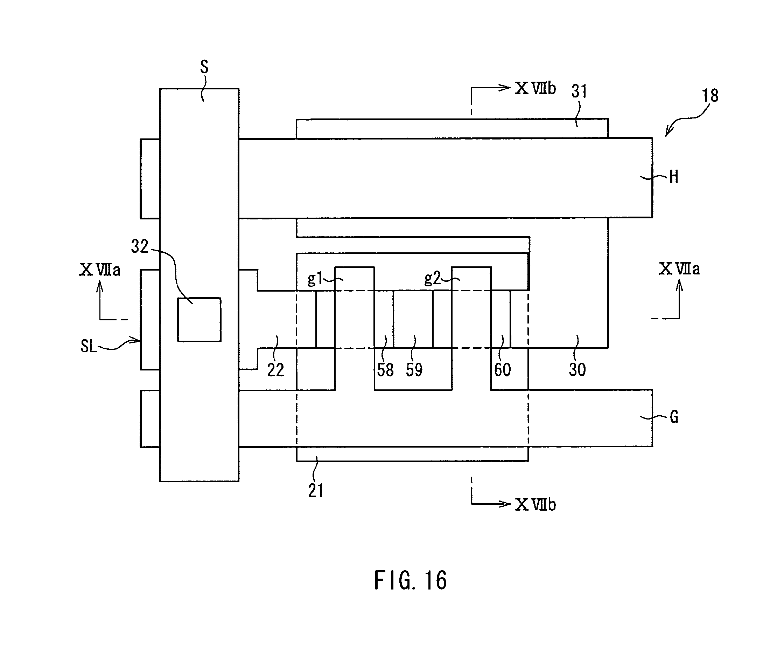

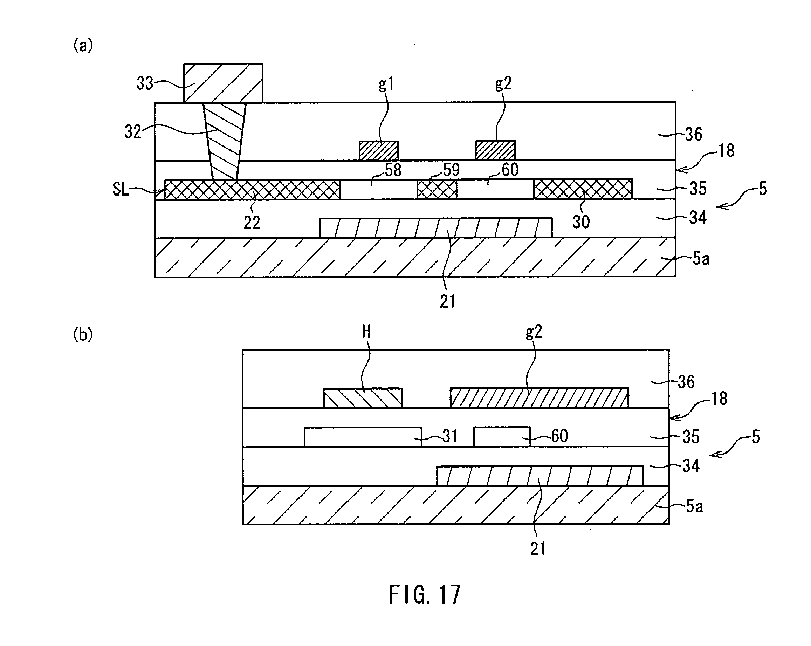

FIG. 16 is a plan view showing a schematic configuration of principal parts of a switching portion according to Embodiment 5. FIGS. 17(a) and 17(b) are cross-sectional views taken along lines XVIIa-XVIIa and XVIIb-XVIIb in FIG. 16, respectively. As shown in the drawings, the main difference of the present embodiment from Embodiment 1 is that offset regions are provided in the silicon layer, and a bottom gate electrode is provided below the offset regions, a part of the source region, and a part of the drain region. It should be noted that the elements in common with Embodiment 1 are denoted by the same reference numerals, and repetitive descriptions of the same are omitted.

As shown in FIGS. 16 and 17, in the switching portion 18 of the present embodiment, offset regions 58 and 60 are formed in the silicon layer SL. Further, the bottom gate electrode 21 is provided so as to be positioned below the offset regions 58 and 60, a part of the source region 22, and a part of the drain region 30. The offset regions 58 and 60, the part of the source region 22, and the part of the drain region 30, which are mentioned above, form a carrier generation region. It should be noted that the "offset regions 58 and 60" refer to areas in the low-concentration impurity-doped region that do not contain an impurity, or areas in the same that contain the same impurity as that of the channel region.

More specifically, as shown in FIGS. 16 and 17, the source region 22, the offset region 58, a high-concentration region 59, the offset region 60, and the drain region 30 are formed in the silicon layer SL. The bottom gate electrode 21 is provided so as to be positioned below the top gate electrodes g1 and g2, and below the part of the source region 22, the offset region 58, the high-concentration region 59, the offset region 60, and the part of the drain region 30.

With the above-described configuration, the same operation and effect as those in Embodiment 1 can be achieved in the present embodiment. In the present embodiment, the offset regions 58 and 60 are formed in the silicon layer SL. Besides, the bottom gate electrode 21 is provided so as to be positioned below the offset regions 58 and 60, a part of the source region 22, and a part of the drain region 30, which are the carrier generation region. With this, in the present embodiment, it is possible to prevent light from entering the carrier generation regions, thereby suppressing the generation of a leakage current. Further, with the provision of the offset regions 58 and 60, a leakage current generated can be reduced further, as compared with the configuration of Embodiment 1.

It should be noted that all the aforementioned embodiments are exemplary, and do not limit the present invention. The technical scope of the present invention is defined by the claims, and all of modifications in the scope equivalent to the configurations described in the claims fall in the technical scope of the present invention as well.

For example, the above-described explanation refers to, as an example, a switching portion for the pixel electrode used in the active matrix substrate for a liquid crystal display device. However, the semiconductor device is not limited at all. More specifically, the semiconductor device is not limited at all, as long as it is a semiconductor device that includes a light shielding film that shields a carrier generation region formed in a semiconductor layer from light, the semiconductor layer being positioned between a main gate electrode and an auxiliary gate electrode, and a potential of the auxiliary gate electrode is determined depending on capacity coupling between the auxiliary gate electrode and the main gate electrode. More specifically, for example, the present invention can be applied to display devices of various types, such as semi-transmissive-type or reflection type liquid crystal panel, an organic EL (electronic luminescence) element, an inorganic EL element, and a field emission display, as well as to an active matrix substrate used in such a display device. Besides, the semiconductor device according to one embodiment of the present invention can be applied to, other than the switching portion for the pixel electrode, a switching portion used in a peripheral circuit such as a driver circuit. Further, the number of the transistors connected in series is not limited to two to four exemplarily described in the above explanation.

Further, the above description explains a case where the main gate electrode is formed with the top gate electrode provided above the semiconductor layer, and the auxiliary gate electrode is formed with the bottom gate electrode provided below the semiconductor layer. However, the main gate electrode may be formed with the bottom gate electrode provided below the semiconductor layer, and the auxiliary gate electrode may be formed with the top gate electrode provided above the semiconductor layer.

Still further, the above explanation describes a case where the bottom gate electrode is used as a light shielding film, but the present invention is not limited to this configuration. More specifically, a transparent electrode may be used for forming the bottom gate electrode, and a light shielding film may be provided below the semiconductor layer and the bottom gate electrode.

It is, however, preferable that the bottom gate electrode functions also as the light shielding film, as in the above-described embodiments, because this makes it possible to more surely prevent the structure of the semiconductor device from becoming complex and bulky, and this makes the manufacture of the semiconductor device easier

Industrial Applicability

The present invention is useful for a semiconductor device that can achieve leakage current reduction and that can be fabricated easily, without its structure becoming complex or the device becoming bulky, an active matrix substrate in which such a semiconductor device is used, and a display device in which such a semiconductor device is used.

**Claims**

1. A semiconductor device provided with a transistor having a main gate electrode and an auxiliary gate electrode, the semiconductor device comprising:

   a semiconductor layer provided between the main gate electrode and the auxiliary gate electrode; and
   a light shielding film that shields one side of a carrier generation region formed in the semiconductor layer from light,
   wherein a potential of the main gate electrode is controlled by a gate signal supplied via a signal line connected to the main gate electrode, and
   a potential of the auxiliary gate electrode is determined depending on capacity coupling between the auxiliary gate electrode and the main gate electrode.

2. The semiconductor device according to claim 1,
   wherein the transistor is formed on a substrate,
   the main gate electrode is formed with a top gate electrode provided on a side opposite to the substrate with respect to the semiconductor layer, and
   the auxiliary gate electrode is formed with a bottom gate electrode provided on a side toward the substrate with respect to the semiconductor layer.

3. The semiconductor device according to claim 2, wherein the bottom gate electrode is used as the light shielding film.

4. The semiconductor device according to any one of claims 1 to 3,
   wherein the transistor is an N-type transistor, and
   a terminal voltage of the transistor, and a capacitance formed between the main gate electrode and the auxiliary gate electrode are set so that the auxiliary gate electrode has a negative potential in the case where the main gate electrode has a potential that causes the transistor to be in an OFF state.

5. The semiconductor device according to any one of claims 1 to 3,
   wherein the transistor is a P-type transistor, and
   a terminal voltage of the transistor, and a capacitance formed between the main gate electrode and the auxiliary gate electrode are set so that the auxiliary gate electrode has a positive potential in the case where the main gate electrode has a potential that causes the transistor to be in an OFF state.

6. The semiconductor device according to any one of claims 1 to 5,
   wherein the semiconductor layer includes a channel region, a low-concentration impurity-doped region, and a high-concentration region,
   the low-concentration impurity-doped region, a part of the high-concentration region, and a part of the channel region on a high-concentration region side fall in the carrier generation region, and
   the light shielding film is provided so as to be positioned on one side of the carrier generation region.

7. The semiconductor device according to any one of claims 1 to 5,
   wherein the semiconductor layer includes an offset region and a high-concentration region,
   the offset region and a part of the high-concentration region fall in the carrier generation region, and
   the light shielding film is provided so as to be positioned on one side of the carrier generation region.

8. The semiconductor device according to any one of claims 1 to 7,
   wherein a transistor with top gate structure is connected in series to the transistor having the main gate electrode and the auxiliary gate electrode.

9. The semiconductor device according to claim 8,
   wherein, among the plurality of transistors connected in series, the transistor to which a drain voltage is applied from outside is the transistor with top gate structure.

10. An active matrix substrate in which the semiconductor device according to any one of claims 1 to 9 is used.

11. A display device in which the semiconductor device according to any one of claims 1 to 9 is used.

FIG. 1

FIG. 2

Source driver — 16

SM
S3
S2
S1

18 · 19 · 20 · COM · P
A

G1 · G2 · ... · GN

Gate driver — 17

Panel control section — 15
Image processing part — 15a
Frame buffer — 15b

Video signal

FIG. 3

FIG. 4

FIG. 5

FIG. 6

EP 2 455 974 A1

FIG. 7

FIG. 8

EP 2 455 974 A1

FIG. 9

FIG. 10

FIG. 11

(a)

(b)

FIG. 12

FIG. 13

FIG. 14

FIG. 15

EP 2 455 974 A1

FIG. 16

EP 2 455 974 A1

(a)

(b)

FIG. 17

| | INTERNATIONAL SEARCH REPORT | International application No. |
|---|---|---|
| | | PCT/JP2010/063463 |

**A. CLASSIFICATION OF SUBJECT MATTER**
*H01L29/786*(2006.01)i, *G02F1/1368*(2006.01)i, *G09F9/30*(2006.01)i, *H01L21/28* (2006.01)i, *H01L21/8234*(2006.01)i, *H01L27/088*(2006.01)i, *H01L29/423* (2006.01)i, *H01L29/49*(2006.01)i
According to International Patent Classification (IPC) or to both national classification and IPC

**B. FIELDS SEARCHED**

Minimum documentation searched (classification system followed by classification symbols)
H01L29/786, G02F1/1368, G09F9/30, H01L21/28, H01L21/8234, H01L27/088, H01L29/423, H01L29/49

Documentation searched other than minimum documentation to the extent that such documents are included in the fields searched
Jitsuyo Shinan Koho          1922–1996     Jitsuyo Shinan Toroku Koho    1996–2010
Kokai Jitsuyo Shinan Koho    1971–2010     Toroku Jitsuyo Shinan Koho    1994–2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 8-211406 A  (AG Technology Corp.),<br>20 August 1996 (20.08.1996),<br>paragraphs [0001], [0009] to [0048]; fig. 1, 2<br>(Family: none) | 1-5,10,11<br>6,7<br>8,9 |
| Y | JP 2002-198537 A  (Semiconductor Energy Laboratory Co., Ltd.),<br>12 July 2002 (12.07.2002),<br>paragraphs [0050] to [0051]<br>& US 2002/0039813 A1    & US 2003/0132436 A1<br>& US 2004/0256623 A1    & US 2008/0135844 A1 | 6,7 |

☐   Further documents are listed in the continuation of Box C.          ☐   See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 04 October, 2010 (04.10.10) | 12 October, 2010 (12.10.10) |

| Name and mailing address of the ISA/<br>Japanese Patent Office | Authorized officer |
|---|---|
| Facsimile No. | Telephone No. |

Form PCT/ISA/210 (second sheet) (July 2009)

**EP 2 455 974 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003008026 A

- JP 2002057341 A